(19) Europäisches Patentamt / European Patent Office / Office européen des brevets

(11) **EP 2 618 163 B1**

(12) **FASCICULE DE BREVET EUROPEEN**

(45) Date de publication et mention de la délivrance du brevet:
**17.09.2014 Bulletin 2014/38**

(51) Int Cl.:
*G01P 15/125* (2006.01)    *G01L 1/14* (2006.01)

(21) Numéro de dépôt: **12151949.0**

(22) Date de dépôt: **20.01.2012**

(54) **Procédé de mesure d'un paramètre physique et circuit électronique d'interface d'un capteur capacitif pour sa mise en oeuvre**

Verfahren zum Messen eines physikalischen Parameters, und elektronischer Schnittstellenschaltkreis eines kapazitiven Sensors zur Umsetzung dieses Verfahrens

Method for measuring a physical parameter and electronic circuit to interface with a capacitive sensor for implementing same

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(43) Date de publication de la demande:
**24.07.2013 Bulletin 2013/30**

(73) Titulaire: **EM Microelectronic-Marin SA**
**2074 Marin (CH)**

(72) Inventeurs:
• **Grosjean, Sylvain**
**25500 Les Fins (FR)**

• **Entringer, Christophe**
**1426 Corcelles-près-Consise (CH)**

(74) Mandataire: **Ravenel, Thierry Gérard Louis et al**
**ICB**
**Ingénieurs Conseils en Brevets SA**
**Faubourg de l'Hôpital 3**
**2001 Neuchâtel (CH)**

(56) Documents cités:
**EP-A1- 1 835 263        EP-A1- 2 343 507**
**WO-A1-2008/107737       WO-A2-2006/070272**
**US-A1- 2009 241 666**

**Description**

L'invention concerne un procédé de mesure d'un paramètre physique, tel qu'une accélération, une vitesse angulaire, une force ou une pression, au moyen d'un circuit électronique d'interface relié à un capteur capacitif.

L'invention concerne également un circuit électronique d'interface d'un capteur capacitif pour la mise en oeuvre du procédé de mesure. Le capteur capacitif est composé d'au moins deux condensateurs montés en différentiel. Une électrode commune des condensateurs est susceptible de se déplacer entre deux électrodes fixes sous l'action par exemple d'une force pour modifier la valeur capacitive de chaque condensateur.

Dans une conception traditionnelle simple d'un tel capteur capacitif, l'électrode commune, qui est mobile, fait partie d'une armature maintenue élastiquement entre les deux électrodes fixes. Dans ce cas, le capteur capacitif peut être capable d'opérer une mesure selon une direction de mouvement de l'électrode mobile. Au repos, cette électrode commune mobile se trouve normalement à égale distance de l'une et de l'autre électrode fixe pour avoir des capacités de valeur égale des deux condensateurs. L'électrode commune mobile peut se déplacer d'une certaine distance en direction de l'une ou l'autre des électrodes fixes sous l'action notamment d'une force. Ainsi la valeur capacitive de chaque condensateur varie inversement. Le circuit électronique d'interface relié au capteur capacitif permet ainsi de fournir un signal de sortie analogique. Ce signal de sortie analogique est défini sous la forme d'une tension dépendant de la variation des capacités des deux condensateurs.

Un tel circuit électronique d'interface d'un capteur capacitif est décrit dans l'article rédigé par MM. H. Leuthold et F. Rudolph, qui est paru dans la revue intitulée "Sensors and actuators" A21-A23 (1990), pages 278 à 281.

Le capteur capacitif peut être un accéléromètre pour effectuer une mesure d'accélération en liaison avec un circuit électronique d'interface. Il peut s'agir d'un accéléromètre uniaxe comme le capteur capacitif susmentionné ou d'un accéléromètre multiaxe ou triaxial pour effectuer une mesure dans les trois directions X, Y et Z. Un tel accéléromètre triaxial du type MEMS peut comprendre une masse unique, c'est-à-dire une masse inertielle commune aux trois paires de condensateurs différentiels, ou trois masses pour les trois paires de condensateurs. Dans le premier cas, une seule électrode commune et six électrodes fixes sont prévues, alors que pour le second cas, une électrode commune avec deux électrodes fixes sont prévues pour chaque paire de condensateurs.

Aussi bien le circuit électronique, que le capteur capacitif, tel qu'un accéléromètre MEMS, sont réalisés chacun dans un substrat semi-conducteur. De ce fait, des capacités parasites à l'entrée du circuit électronique s'ajoutent aux capacités des condensateurs du capteur capacitif MEMS. Ces capacités parasites ne dépendent pas du déplacement de l'électrode mobile, ce qui a pour conséquence de créer des non-linéarités et également de faire baisser la sensibilité ou le gain du circuit électronique. Il en est de même avec le capteur capacitif MEMS, où le potentiel du substrat lors du fonctionnement du capteur crée également des non-linéarités. Ainsi la force électrostatique mesurée n'est pas nulle dans un mode de repos du capteur et du circuit électronique. De par l'influence du potentiel du substrat sur la force électrostatique, cela conduit à une variation de la force réelle mesurée, qui est appliquée sur l'électrode commune mobile, ce qui est un inconvénient.

Pour effectuer une mesure d'une force, d'une accélération ou d'une pression par l'intermédiaire du circuit électronique, les électrodes fixes de deux condensateurs ou des paires de condensateurs sont polarisées ou excitées cycliquement par des tensions de polarité opposée par rapport à une tension de référence au repos. En polarisant les deux électrodes fixes à des niveaux de tension différents, la différence de charges sur l'électrode mobile peut être mesurée et convertie en au moins une tension en sortie du circuit électronique. Lorsque la ou les tensions de sortie sont stabilisées à leur valeur finale, la charge totale sur l'électrode mobile devient nulle. Par la suite, ces tensions de sortie sont fournies échantillonnées à un circuit de traitement.

Comme la mesure d'une force, d'une accélération ou d'une pression, est dépendante des non-linéarités susmentionnées et de tout écart de tension lié aux composants électroniques non appariés, la demande de brevet EP 1 835 263 propose une solution à ce problème. Une double structure symétrique dans le circuit électronique est proposée notamment avec deux intégrateurs à la suite de l'amplificateur à transfert de charges. Chaque intégrateur fournit en sortie une tension de sortie analogique correspondante selon une polarisation positive des électrodes ou une polarisation négative des électrodes. Grâce à cela, un écart de tension (offset) dû à la technologie ou à la variation de tension d'alimentation peut être minimisé voire supprimé à l'aide des deux tensions de sortie analogiques des intégrateurs. De plus, le potentiel du substrat n'a plus d'importance comme le circuit électronique comprend une double structure identique à fonctionnement totalement symétrique.

Cependant un inconvénient d'un tel circuit électronique du document de brevet EP 1 835 263, est qu'il fournit des signaux de sortie, tels que des tensions de sortie, sous forme analogique. Ceci nécessite l'emploi de deux intégrateurs. Cela ne permet pas de réduire de manière suffisante la taille des composants intégrés et la consommation électrique du circuit électronique intégré. De plus, ce circuit électronique n'est prévu que pour effectuer une mesure avec un capteur capacitif selon un seul axe de mesure.

Il est donc préféré de réaliser un circuit électronique, qui fournit en sortie des signaux numériques de mesure. A ce titre, on peut citer le document de brevet WO 2004/113930, qui décrit un tel circuit électronique relié à un capteur capacitif uniaxe ou multiaxe pour la mesure d'une accélération. Il est prévu à la suite de l'amplificateur à transfert de charges, qui est relié à l'électrode commune mobile, une logique spécifique à chaque axe de mesure, qui traite des signaux numériques de mesure. Chaque logique fournit en sortie un signal binaire de mesure représentatif d'un niveau de tension de mesure fonction du déplacement de l'électrode mobile par rapport aux électrodes fixes pour chaque axe successivement. Le signal binaire de mesure est fourni successivement pour chaque axe à un convertisseur numérique-analogique. Ce convertisseur fournit dans une phase de chaque cycle de mesure pour un axe sélectionné, une tension de mesure aux électrodes fixes en alternance avec une phase de polarisation des électrodes fixes à une tension haute et une tension basse d'une source de tension d'alimentation. Le signal binaire obtenu en sortie de chaque logique est incrémenté ou décrémenté d'une unité à chaque série de phases de mesure, jusqu'à ce que la charge totale sur l'électrode mobile devienne nulle. Bien que la taille des composants électroniques et la consommation électrique soient réduites, les non-linéarités susmentionnées et les écarts de tension (offset) ne sont pas supprimés, ce qui est un inconvénient. De plus, le temps pour stabiliser le signal numérique de sortie pour chaque axe de mesure est relativement long, ce qui est un autre inconvénient.

Comme pour le précédent document, le document de brevet WO 2008/107737 décrit un circuit électronique d'interface d'un capteur de mesure d'une accélération. Un signal analogique de mesure est mémorisé à la suite d'un amplificateur à transfert de charges dans une phase d'un cycle de mesure suite à une polarisation des électrodes fixes des condensateurs. Le signal analogique est converti en un signal numérique mémorisé dans une logique du circuit électronique. Le signal numérique mémorisé est par la suite converti par un convertisseur numérique-analogique en un signal retour analogique sous forme de tension, qui est appliquée à toutes les électrodes du capteur dans une phase successive de chaque cycle de mesure. Dans un cycle de mesure, les électrodes fixes sont polarisées successivement par une première polarisation et par une seconde polarisation inverse à la première polarisation. Cela permet de supprimer les courants de fuite du circuit électronique. Par contre, beaucoup d'étapes sont nécessaires pour obtenir en sortie un signal de mesure d'un paramètre physique, ce qui constitue un inconvénient.

Dans le document de brevet EP 2 343 507, il est décrit un circuit électronique d'interface d'un capteur de mesure uniaxe ou triaxial. Un traitement numérique des signaux de mesure est effectué à la suite de l'amplificateur à transfert de charges dans une unité logique. Des signaux numériques de mesure suite à une polarisation positive et à une polarisation négative sont mémorisés dans des registres correspondants de l'unité logique. Un convertisseur numérique-analogique est également utilisé pour convertir les signaux numériques successivement pour chaque axe dans un cycle de mesure, en une tension aux électrodes du capteur. Pour obtenir des valeurs finales de mesure de l'accélération pour chaque axe, il est utilisé dans l'unité logique, tout d'abord un algorithme par dichotomie pour un certain nombre de cycles de mesure, avant de terminer par des étapes de sur-échantillonnage. Avec cet algorithme par dichotomie, la mesure débute toujours, lors de chaque conversion, à la moitié de la marge de mesure notamment à $V_{REG}/2$. Si une erreur survient lors de cette première mesure avec un grand pas de changement dans l'unité logique, la valeur finale au terme de tous les cycles de mesure, sera inévitablement fausse, ce qui constitue un inconvénient.

L'invention a donc pour but de pallier aux inconvénients de l'état de la technique susmentionnés en fournissant un procédé de mesure d'un paramètre physique au moyen d'un circuit électronique d'interface relié à un capteur capacitif, qui permet de fournir rapidement et sans erreur des signaux de sortie précis en supprimant également tout écart de tension.

A cet effet, l'invention concerne un procédé de mesure d'un paramètre physique au moyen d'un circuit électronique d'interface relié à un capteur capacitif, qui comprend les caractéristiques définies dans la revendication indépendante 1.

Des étapes particulières du procédé de mesure sont définies dans les revendications dépendantes 2 à 7.

Un avantage du procédé de mesure réside dans le fait qu'au moins un signal numérique de sortie d'une mesure d'un paramètre physique peut être fourni rapidement en sortie du circuit électronique et sans erreur. Par le procédé de mesure, il est défini un bon compromis entre de rapides changements par exemple d'une accélération, et de fourniture de signaux de mesure, et la réduction du bruit au moyen de petits pas d'adaptation en particulier au terme de chaque conversion.

Pour ce faire, le procédé de mesure utilise avantageusement un algorithme auto-adaptif pour détecter de grands changements d'accélération notamment entre deux conversions successives ou dans une même conversion. Après un certain nombre de cycles de mesure à petits pas, un compteur de décisions détermine si une augmentation continuelle ou une diminution continuelle des signaux numériques, intervient, afin d'adapter la taille de chaque pas des cycles de mesure subséquents. L'adaptation à une grande valeur numérique de chaque pas intervient, dès qu'un seuil prédéterminé de comptage d'un compteur de décisions est dépassé. Dès que le compteur de décisions détermine un changement de signe dans les cycles de mesure à grande valeur de pas, la taille des pas de chaque cycle de mesure est réadaptée à de petits pas pour réduire le bruit.

Un autre avantage du procédé de mesure réside dans le fait qu'il peut être repris, au terme de chaque conversion, le dernier signal numérique mémorisé de chaque registre correspondant, pour pouvoir débuter une conversion de mesure subséquente. Pour débuter une nouvelle conversion, il peut également être utilisé une moyenne finale des signaux numériques successifs stockés dans un registre correspondant dans au moins une partie finale de cycles successifs de mesure à petits pas d'adaptation. Une sélection de la dernière valeur numérique stockée de chaque signal numérique ou de la moyenne des signaux numériques dans la partie finale de cycles de mesure, peut être effectuée sur la base d'un comptage par le compteur de décisions.

Avantageusement en reprenant la précédente valeur numérique du registre de polarisation positive et du registre de polarisation négative de chaque axe de mesure, cela permet de stocker la variation de la conversion précédente et de mémoriser ainsi l'offset précédent. Sans grands changements d'accélération d'une conversion à une conversion subséquente, il est ainsi possible de n'utiliser que des cycles de mesure à petits pas. Lors d'une brusque transition d'accélération, une adaptation de la taille de chaque pas des cycles de mesure successifs peut intervenir dans une conversion de mesure après un certain nombre de cycles à petits pas. La taille de chaque pas est réadaptée à une taille de petits pas une fois qu'un changement de signe est détecté par l'intermédiaire du compteur de décisions. Une moyenne des signaux numériques mémorisés depuis le passage aux cycles de mesure à petits pas est effectuée pour stocker la valeur numérique finale pour chaque axe de mesure et chaque polarisation. Cette valeur numérique finale de chaque registre est ainsi utilisée pour débuter une nouvelle conversion de mesure.

A cet effet, l'invention concerne également un circuit électronique d'interface d'un capteur capacitif cité ci-devant pour la mise en oeuvre du procédé de mesure, qui comprend les caractéristiques définies dans la revendication indépendante 8.

Des formes d'exécution spécifiques du circuit électronique sont définies dans les revendications dépendantes 9 à 11.

Un avantage du circuit électronique d'interface d'un capteur physique réside dans le fait qu'il permet d'obtenir rapidement des signaux numériques de mesure stabilisés en sortie grâce à un traitement numérique directement après l'amplificateur à transfert de charges. Ces signaux numériques de mesure sont traités dans l'unité logique. Un algorithme auto-adaptif mémorisé dans l'unité logique permet d'adapter la taille des pas d'adaptation des cycles de mesure pour fournir des signaux numériques adaptés en fonction d'une détection d'un grand changement du paramètre physique mesuré durant une conversion de mesure. Deux signaux numériques dépendant d'une polarisation positive ou première polarisation, et d'une polarisation négative ou seconde polarisation des électrodes fixes de la paire de condensateurs, sont généralement fournis dans l'unité logique. Ceci permet par combinaison des signaux numériques de supprimer tout écart de tension notamment des composants du circuit électronique.

Un autre avantage du circuit électronique d'interface d'un capteur physique réside dans le fait qu'il peut fournir deux signaux numériques pour chaque axe d'un capteur triaxial. Un seul amplificateur, une unité logique et un seul convertisseur numérique-analogique sont ainsi prévus pour la mesure du paramètre physique selon les trois axes. Ceci limite la redondance du circuit électronique.

Les buts, avantages et caractéristiques du procédé de mesure d'un paramètre physique et le circuit électronique d'interface d'un capteur capacitif pour sa mise en oeuvre apparaîtront mieux dans la description suivante en regard des dessins sur lesquels :

- la figure 1 représente de manière simplifiée un circuit électronique d'interface relié à un capteur capacitif pour la mise en oeuvre du procédé de mesure d'un paramètre physique selon l'invention,
- la figure 2 représente un diagramme temporel d'une conversion du procédé de mesure selon l'invention, selon un axe de mesure en partant de la valeur numérique d'une précédente conversion, et dans le cas où il n'y a pas de variation du paramètre physique à mesurer, et
- les figures 3a et 3b représentent des diagrammes temporels comparatifs d'une conversion selon un axe de mesure d'une part sans application de l'algorithme auto-adaptatif et d'autre part en appliquant l'algorithme auto-adaptatif du procédé de mesure selon l'invention, lors d'un brusque changement du paramètre physique à mesurer, et en partant de la valeur numérique d'une précédente conversion.

Dans la description suivante comme différents composants du circuit électronique d'interface d'un capteur à condensateurs différentiels sont bien connus dans ce domaine technique, ils ne seront pas tous explicités en détail. L'accent porte principalement sur le procédé de mesure du paramètre physique au moyen d'un circuit électronique, qui fournit des signaux numériques de mesure en sortie.

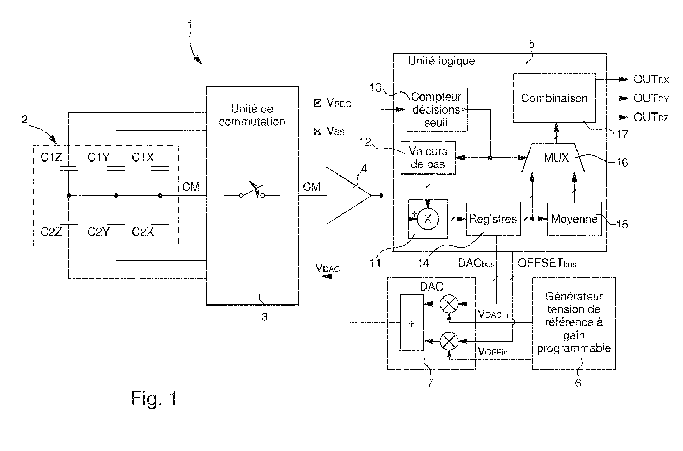

La figure 1 montre un schéma simplifié des différents composants du circuit électronique 1 d'interface d'un capteur capacitif 2 selon l'invention. Dans cette forme d'exécution, il est prévu de relier un capteur capacitif 2 triaxial du type MEMS à masse unique au circuit électronique 1, même s'il est tout à fait concevable également de connecter un capteur triaxial à trois masses mobiles ou un capteur uniaxe. Ce capteur capacitif est donc composé de trois paires de condensateurs C1X, C2X, C1Y, C2Y, C1Z et C2Z. Les deux condensateurs de chaque paire sont montés en différentiel. Une électrode commune CM des paires de condensateurs peut se déplacer sous l'action notamment d'une force entre deux électrodes fixes de chaque paire de condensateurs pour effectuer une mesure tenant compte des trois axes X, Y et Z.

Le circuit électronique 1 peut fournir des signaux numériques de mesure pour chaque axe, qui sont relatifs à un paramètre physique, tel qu'une accélération, une vitesse angulaire, une pression ou une force, en fonction du déplacement de l'électrode commune mobile. Dans le cas d'une mesure d'accélération, le circuit électronique peut être configuré pour fournir des signaux numériques de mesure entre des valeurs minimum et maximum d'accélération. Il peut être choisi par exemple de configurer le circuit électronique pour fournir des signaux numériques de mesure dans la gamme de -2g à +2g d'accélération. Une variation de tension de l'ordre de 3 à 20 mV peut être comptée pour 1 g d'accélération.

L'électrode commune mobile CM peut faire partie d'une armature du capteur maintenue élastiquement dans une position centrale au repos entre les deux électrodes fixes de chaque paire de condensateurs C1X, C2X, C1Y, C2Y, C1Z et C2Z. Le circuit électronique 1 peut être alimenté par une source de tension d'alimentation continue non représentée. Cette source de tension d'alimentation fournit à une première borne une tension régulée haute $V_{REG}$ et à une seconde borne une tension basse $V_{SS}$. La tension basse peut être définie à 0 V, alors que la tension régulée haute peut être fixée à 1.65 V par exemple. L'électrode fixe de chaque condensateur peut être polarisée dans une phase d'un cycle de mesure, soit à la tension haute $V_{REG}$, soit à la tension basse $V_{SS}$ dans un mode de fonctionnement du circuit électronique. De ce fait, comme les deux condensateurs C1X, C2X, C1Y, C2Y, C1Z et C2Z de chaque paire ont une valeur capacitive égale dans un mode de repos du capteur 2, la tension sur l'électrode commune CM est de préférence égale au repos à une tension intermédiaire $V_{REG}/2$ entre la tension régulée $V_{REG}$ et la tension basse Vss à 0 V.

Les signaux numériques de mesure fournis par le circuit électronique 1 sont proportionnels pour deux condensateurs C1 et C2 à (C1-C2)/(C1+C2). Une fois que les signaux numériques de mesure sont stabilisés à une mesure finale du paramètre physique au terme de chaque conversion, tout écoulement de charges sur les deux condensateurs de chaque paire s'annule. Ainsi le but du circuit électronique consiste à trouver une tension à appliquer sur chaque électrode fixe dans une phase d'égalisation des charges sur la base d'un précédent signal numérique, qui satisfait à $(V_{REG}-V_{DAC}) \cdot C1 = (V_{DAC}-V_{SS}) \cdot C2$. Ceci est atteint quand $V_{DAC} = (V_{REG}/2) \cdot (1 + (C1-C2)/(C1+C2))$.

Le circuit électronique 1 comprend un amplificateur à transfert de charges du type comparateur 4, qui est relié directement à l'électrode mobile CM des condensateurs par l'intermédiaire d'une unité de commutation 3. L'unité de commutation 3 reçoit les tensions $V_{REG}$, $V_{SS}$ et $V_{DAC}$ à appliquer aux électrodes du capteur selon les phases d'un cycle de mesure. La tension régulée $V_{REG}$ et la tension basse $V_{SS}$ sont appliquées aux électrodes fixes, alors que la tension $V_{DAC}$, d'un convertisseur numérique-analogique 7 en contre-réaction, est appliquée à toutes les électrodes. Dans chaque cycle de mesure, une alternance entre une phase, où toutes les électrodes reçoivent une tension $V_{DAC}$ d'une précédente mesure et une phase de polarisation des électrodes fixes entre $V_{REG}$ et $V_{SS}$ intervient.

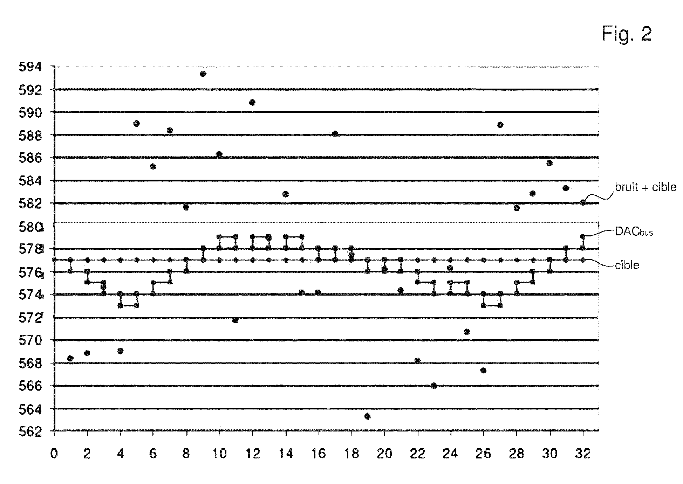

Pour comprendre comment les tensions sont appliquées aux électrodes durant chaque cycle de mesure et pour les trois axes de mesure, il est fait référence à la demande de brevet EP 2 343 507 A1, qui est incorporée ici par référence. A ce titre, toutes les tensions sont expliquées en référence à la figure 2 de cette demande de brevet, et décrites aux paragraphes 40 à 48. Dans chaque premier demi-cycle de mesure une polarisation positive successive des électrodes fixes pour chaque axe de mesure est effectuée, en alternance avec la tension $V_{DAC}$ fournie à toutes les électrodes et qui est relative à un signal numérique de mesure précédent de la polarisation positive pour chaque axe de mesure. La polarisation positive peut être une première polarisation des électrodes fixes. Dans chaque second demi-cycle de mesure une polarisation négative successive des électrodes fixes est effectuée, en alternance avec la tension $V_{DAC}$ fournie à toutes les électrodes et qui est relative à un signal numérique de mesure précédent de la polarisation négative pour chaque axe de mesure. La polarisation négative peut être une seconde polarisation. La polarisation positive entre $V_{REG}$ et $V_{SS}$ est l'inverse de la polarisation négative.

Chaque cycle de mesure d'accélération compte 12 phases, dont 3 phases de polarisation positive pour chaque axe de mesure, et 3 phases de polarisation négative, pour un capteur triaxial, alors qu'uniquement 4 phases sont suffisantes pour un capteur uniaxe. De plus, plusieurs cycles de mesure successifs sont nécessaires pour obtenir les valeurs finales numériques de mesure pour chaque axe de chaque conversion comme expliqué ci-après. Pour chaque conversion, il peut être effectué par exemple 16, 32, 40 ou 64 cycles de mesure successifs. Cependant à la différence de la succession de cycles de mesure présentée dans cette demande de brevet, chaque conversion du procédé de mesure selon l'invention ne débute de préférence pas au milieu de la marge de mesure à $V_{REG}/2$. Chaque conversion débute en prenant en compte la précédente valeur numérique mémorisée d'une précédente conversion respectivement pour chaque axe de mesure et pour une polarisation positive et une polarisation négative.

L'amplificateur comparateur 4 est de conception très simple du type de celui décrit dans l'article intitulé "A 1 mV MOS Comparator" de la revue IEEE J. Solid-State Circuits, vol. SC-13. pp. 294-298 de juin 1978. Cet amplificateur comparateur 4 comprend généralement un condensateur en entrée relié à l'électrode commune CM, suivi d'étages amplificateurs pour fournir en sortie un signal de forme numérique en tout ou rien. Cet amplificateur à transfert de charges a un très haut gain. Le signal de sortie de l'amplificateur est à l'état "1" proche de la tension régulée $V_{REG}$ quand la tension sur l'électrode mobile CM augmente par l'accumulation de charges positives dans les cycles de mesure. Par contre, le signal de sortie de l'amplificateur passe à l'état "0" proche de la tension basse $V_{SS}$ quand la tension sur l'électrode mobile CM diminue par l'accumulation de charges négatives dans les cycles de mesure.

Le circuit électronique 1 comprend encore une unité logique 5, qui comprend des moyens de mémorisation, dans lesquels sont mémorisés notamment différents paramètres de configuration, et principalement l'algorithme de mesure du procédé selon l'invention. L'unité logique 5 du circuit électronique comprend encore un processeur non représenté, qui est cadencé par un signal d'horloge traditionnel, de manière à contrôler l'exécution de toutes les étapes nécessaires du procédé de mesure d'un paramètre physique, notamment d'une accélération.

L'unité logique 5 comprend encore au moins un compteur 13 relié au processeur, et plusieurs registres 14 pour stocker des signaux numériques sous forme de mots binaires de mesure pour chaque axe de mesure. Il est prévu deux registres non représentés par axe de mesure. Ainsi pour la mesure d'une accélération avec un capteur triaxial, l'unité logique 5 compte six registres pour les trois axes de mesure. Pour chaque axe, un premier registre reçoit un premier signal numérique de mesure provenant d'une polarisation définie positive (pol à "0") des électrodes fixes de la paire de condensateurs correspondante, alors qu'un second registre reçoit un second signal numérique de mesure provenant d'une polarisation définie négative (pol à "1") des électrodes fixes de la paire de condensateurs correspondante. La polarisation négative est simplement une polarisation inversée de la polarisation positive.

Lors de chaque cycle de mesure, le premier signal numérique et le second signal numérique pour chaque axe stocké dans un registre correspondant, est incrémenté ou décrémenté d'une certaine valeur numérique fonction d'un pas déterminé et programmé. Pour ce faire, l'unité logique 5 comprend un élément de multiplication 11, qui reçoit le signal de sortie de l'amplificateur comparateur 4, et une valeur numérique d'un élément 12 de fourniture d'une valeur de pas. Si la sortie de l'amplificateur comparateur 4 est à l'état haut "1 ", cela signifie une augmentation de tension sur l'électrode mobile CM. Dans ces conditions, l'élément de multiplication 11 multiplie la valeur numérique de pas par +1 pour pouvoir ajouter la valeur numérique de pas au précédent signal numérique stocké dans le registre correspondant 14. Par contre si la sortie de l'amplificateur comparateur 4 est à l'état bas "0", cela signifie une diminution de tension sur l'électrode mobile CM. Dans ces conditions, l'élément de multiplication 11 multiplie la valeur numérique de pas par -1 pour pouvoir soustraire la valeur numérique de pas au précédent signal numérique stocké dans le registre correspondant 14.

Au début de chaque conversion, le signal numérique initial pour chaque axe et fonction de la polarisation positive et de la polarisation négative, correspond au signal numérique mémorisé dans un registre correspondant 14 d'une précédente conversion de mesure. Pour les premiers cycles de mesure, l'unité logique 5 est configurée pour commander l'élément 12 de fourniture d'une valeur de pas, afin qu'une petite ou première valeur de pas soit ajoutée ou soustraite du signal numérique d'un registre correspondant 14 dans chaque cycle de mesure en fonction du niveau de la sortie de l'amplificateur comparateur 4. Cette petite valeur numérique de pas peut avantageusement être choisie pour valoir 1, voire 2 en fonction du bruit à tenir compte.

Après avoir été remis à zéro au début de chaque conversion de mesure, le compteur de décisions 13 compte ou décompte en fonction de l'état du signal de sortie de l'amplificateur comparateur 4 à chaque cycle de mesure. S'il n'y a qu'une augmentation continuelle ou une diminution continuelle du compteur 13 à chaque premier cycle de mesure successif de la conversion, l'unité logique 5 commande l'élément 12 pour adapter la valeur numérique de chaque pas à une plus grande valeur de pas ou seconde valeur de pas. Cette adaptation intervient dès que le nombre compté successivement de "1" ou de "0" excède un seuil prédéterminé, par exemple après 8, 16, 32 ou un autre nombre de cycles de mesure successifs. Par exemple si après 8 cycles de mesure successifs, il n'y a qu'une augmentation continuelle ou une diminution continuelle du compteur 13, la valeur de chaque pas à ajouter ou à soustraire à un précédent signal numérique d'un registre correspondant, est augmentée. Cette grande ou seconde valeur de pas peut être programmée de préférence à une valeur égale à 8, mais peut aussi être fixée à une autre valeur, telle que 16, 32, 64 ou une autre grande valeur sur une échelle de 0 à 1023 pour chaque mot binaire sur 10 bits. Cette grande valeur de pas peut également être variable notamment progressivement variable au-dessus de la valeur de 2 ou d'une conversion à une autre conversion. Chaque mot binaire peut être sur plus de 10 bits ou moins de bits en fonction de l'application prévue du circuit électronique avec le capteur capacitif.

Une fois que la valeur de pas a été adaptée à une grande valeur, cette grande valeur de pas est ajoutée ou soustraite à un précédent signal numérique d'un registre correspondant 14 dans chaque cycle de mesure successif. Dès qu'un changement de signe du compteur 13 est détecté dans ces cycles de mesure successifs à grande valeur de pas, l'unité logique 5 commande à nouveau l'adaptation de la valeur de pas à une petite valeur et ceci jusqu'au terme de la conversion de mesure. Ceci est effectué pour les 6 registres successivement. Ainsi une auto-adaptation de la valeur des pas à ajouter ou à soustraire s'opère de manière à tenir compte d'un grand changement du paramètre physique, tel qu'une accélération d'une conversion à une conversion subséquente, ou dans une même conversion de mesure.

Si un grand changement d'accélération intervient dans une même conversion, il se peut qu'une adaptation de la valeur des pas soit nécessaire dans une partie des cycles de mesure finaux de ladite conversion. Cela signifie qu'une réadaptation à une petite valeur dans la conversion peut ne pas survenir et uniquement la valeur finale de chaque signal numérique est prise en compte pour une conversion subséquente.

La durée de chaque conversion de mesure pour les trois axes de mesure, peut être inférieure à 1'500 $\mu$s, si chaque phase est de durée de l'ordre de 2 $\mu$s ou inférieure. Bien entendu, cette durée dépend également du nombre d'échantillons prélevés pour chaque axe et chaque polarisation positive ou négative. Si uniquement 32 échantillons sont prélevés dans chaque conversion de mesure, la durée de chaque conversion peut être inférieure à 1 ms.

Pour chaque conversion de mesure, dans laquelle il peut être prévu 16, 32, 40 ou 64 cycles de mesure successifs, une moyenne de tous les signaux numériques successifs stockés dans un registre correspondant une fois que l'unité logique 5 a réadapté la valeur des pas à une petite valeur, peut être effectuée. Si aucune adaptation de la valeur de pas n'est intervenue durant toute la conversion de mesure, quand il n'y a pas de grands changements d'une conversion à une conversion subséquente, la moyenne d'une grande partie finale ou de tous les signaux numériques successifs stockés, peut être effectuée. Au moins 8, 10 ou 12 échantillons dans des cycles de mesure successifs à petits pas, peuvent être en principe nécessaires pour effectuer une moyenne.

La moyenne des signaux numériques successifs, est effectuée par l'intermédiaire d'un élément 15 d'exécution d'une moyenne relié aux registres 14. Une mémoire particulière lié à l'élément 15 à moyenne peut stocker tous les signaux numériques successifs d'un registre correspondant. Une telle moyenne des résultats de cycles de mesure successifs à petits pas, peut bien entendu être effectuée, sauf dans le cas où un brusque changement d'accélération survient dans la même conversion et dans une partie finale des cycles de mesure. Suite à ce brusque changement, la valeur de pas est adaptée à une grande valeur de pas, et une augmentation ou une diminution continuelle à chaque cycle de mesure à grande valeur de pas peut survenir jusqu'au terme de la conversion. Dans ces conditions avec un grand changement du paramètre physique, uniquement le dernier signal numérique pour chaque axe et chaque polarisation est gardé en mémoire pour débuter une nouvelle conversion de mesure.

Avec cet algorithme auto-adaptif du procédé de mesure, il est détecté en général un changement de signe du compteur de décisions 13 après avoir été adapté pour la fourniture d'une grande valeur de pas à chaque cycle de mesure. Une moyenne peut ainsi être effectuée sur les échantillons stockés à chaque cycle de mesure après la réadaptation à une petite valeur de pas, jusqu'au terme de la conversion.

Dans le cas où le nombre compté par le compteur de décisions n'excède pas le seuil prédéterminé, le multiplexeur 16 fournit en sortie la moyenne des différents signaux numériques stockés dans une partie finale de cycles de mesure successifs, qui est fournie par l'élément 15 à moyenne. Cette moyenne peut être considérée comme une intégration des signaux numériques successivement mémorisés. Au terme de chaque conversion, l'unité logique 5 fournit, par combinaison ou addition de deux registres par axe de mesure dans un élément de combinaison 17, relié au multiplexeur 16, un signal numérique de sortie par $OUT_{DX}$, $OUT_{DY}$, $OUT_{DZ}$. Dans ces signaux de sortie combinés pour chaque axe, tout écart de tension (offset) a été supprimé.

Il est à noter qu'au terme de chaque conversion, soit le dernier signal numérique de chaque registre, soit la moyenne mémorisée de différents signaux numériques au moins dans une partie finale de cycles de mesure, est utilisé pour une nouvelle conversion. Cela permet avantageusement de bénéficier des précédentes variations de valeurs de précédentes conversions tout en mémorisant l'offset précédent. Dans ces conditions, il n'est plus forcément nécessaire d'avoir une adaptation à une grande valeur de pas pour les cycles de mesure pour une conversion subséquente sans changement significatif du paramètre physique à mesurer. Avec les cycles de mesure par l'ajout ou le retrait d'une petite valeur de pas, cela permet avantageusement de réduire les effets du bruit.

Il est encore à noter que suite à l'adaptation à une grande valeur de pas pour des cycles de mesure dans la conversion de mesure, cette grande valeur de pas peut être progressivement diminuée ou augmentée pour permettre de détecter plus ou moins rapidement un changement de signe du compteur. Un optimum de la taille des grands pas peut être déterminé en prenant en compte le rapport entre le bruit et la racine carrée de la bande passante. Avec de grandes valeurs de pas signifiant une grande bande passante, le bruit augmente également. Ainsi un bon compromis doit être déterminé entre l'adaptation à grande valeur de pas des cycles de mesure pour atteindre rapidement la valeur cible d'accélération à mesurer, et le bruit généré. En principe avec une grande valeur de pas fixée à 8, un optimum a été déterminé, mais peut néanmoins varier d'une conversion à une autre conversion.

Chaque signal numérique de mesure ou mot binaire DACbus stocké dans les registres 14 est fourni successivement dans chaque cycle de mesure au convertisseur numérique-analogique DAC 7 de manière à convertir notamment chaque mot binaire DACbus en une tension de sortie $V_{DAC}$. Comme précédemment expliqué, cette tension de sortie du DAC permet de décharger dans une des phases de chaque cycle de mesure tous les condensateurs C1X, C2X, C1Y, C2Y, C1Z, C2Z et CM à une valeur de tension dépendant du mot binaire DACbus d'un axe particulier. Le mot binaire DACbus est multiplié dans un premier multiplicateur dans le convertisseur numérique-analogique 7 par une tension de référence $V_{DACin}$, qui provient d'un générateur de tension de référence à gain programmable 6. Cette tension de référence peut être fournie au moyen d'un diviseur résistif connecté entre la tension régulée $V_{REG}$ et la masse $V_{SS}$.

L'unité logique 5 fournit aussi un mot binaire d'ajustage OFFSETbus (10 bits) d'un écart de tension relatif au capteur MEMS en entrée. Ce mot binaire d'ajustage OFFSETbus est multiplié dans un second multiplicateur dans le convertisseur numérique-analogique 7 avec une tension d'ajustage $V_{OFFin}$, qui provient du générateur de tension de référence à gain programmable 6. Cette tension d'ajustage $V_{OFFin}$ peut également être obtenue au moyen d'un diviseur résistif connecté entre la tension régulée $V_{REG}$ et la masse $V_{SS}$. Une addition des tensions de sortie des deux multiplicateurs du convertisseur 7 est ensuite effectuée de manière que le convertisseur numérique-analogique fournisse en sortie la tension $V_{DAC}$. L'écart de tension lié au capteur MEMS ne dépend pas de la polarisation appliquée aux électrodes fixes des paires de condensateurs. Une étape préliminaire de calibrage pour corriger cet écart de tension (offset) du capteur MEMS peut être effectuée une fois pour toute avant la mesure du paramètre physique du circuit électronique 1.

Comme les mots binaires DACbus et OFFSETbus peuvent être par exemple sur 10 bits de 0 à 1023, on peut exprimer la tension de sortie $V_{DAC}$ provenant d'une polarisation positive (polarité "0") des électrodes fixes d'une part et d'une polarisation négative (polarité "1 ") des électrodes fixes d'autre part. Cependant, chaque mot binaire peut aussi être défini sur plus de 10 bits ou moins de 10 bits en fonction de l'application souhaitée du circuit électronique avec le capteur capacitif. Ces deux équations eq(0) et eq(1) des deux tensions $V_{DAC}$ sont exprimées comme suit :

$$eq(0): V_{DAC}(0) = V_{REG}/2 + V_{DACoffset} + (DACbus(0)-512) \cdot K_{DAC} \cdot V_{REG} + (OFFSETbus-512) \cdot K_{OFF} \cdot V_{REG}$$

$$eq(1): V_{DAC}(1) = V_{REG}/2 + V_{DACoffset} - (DACbus(1)-512) \cdot K_{DAC} \cdot V_{REG} - (OFFSETbus-512) \cdot K_{OFF} \cdot V_{REG}$$

$K_{DAC}$ est un facteur qui définit le gain du système. Ce gain peut être programmable par exemple en générant une tension $V_{DACin}$ qui provient d'un diviseur résistif du générateur de tension de référence 6. $K_{OFF}$ est un facteur, qui définit le gain de la circuiterie d'ajustage de l'écart de tension (offset) du capteur MEMS. Ce gain peut être adapté selon la plage d'ajustage désirée par exemple en générant une tension $V_{OFFin}$ qui provient d'un autre diviseur résistif du générateur de tension de référence 6. DACbus(0) définit le mot binaire sur 10 bits, qui provient d'un premier registre de l'unité logique 5, qui est appliqué au convertisseur DAC 7 durant les phases de la polarisation positive. Ce mot binaire est défini de 0 à 1023. DACbus(1) définit le mot binaire sur 10 bits, qui provient d'un second registre de l'unité logique 5, qui est appliqué au convertisseur DAC 7 durant les phases de la polarisation négative. Ce mot binaire est défini de 0 à 1023. OFFSETbus définit le mot binaire d'ajustage sur 10 bits, qui est appliqué au convertisseur DAC 7 pour réaliser la correction de l'écart de tension (offset) lié au capteur MEMS. $V_{DACoffset}$ représente l'écart parasite de tension (offset) du convertisseur DAC 7, ce qu'on veut notamment supprimer. Cet écart parasite de tension englobe tout l'écart de tension lié au circuit électronique (amplificateur, convertisseur,...), et peut aussi représenter le bruit à basse fréquence ("flicker noise" en terminologie anglaise).

Il est encore à noter que DACbus(0) peut être différent de DACbus(1) si une accélération est mesurée, car ces mots binaires dépendent de l'état de la polarisation appliquée aux électrodes fixes. Par contre OFFSETbus ne dépend absolument pas de la polarisation appliquée aux électrodes fixes. Ainsi OFFSETbus est choisi de manière définitive après l'étape préliminaire de calibrage du capteur MEMS lié au circuit électronique comme indiqué ci-devant. Ce mot binaire d'ajustage peut être mémorisé dans les moyens de mémorisation de l'unité logique 5. Dans le cas où le capteur MEMS a besoin d'une variation de tension $V_{MEMS}$ autour de $V_{REG}/2$ pour réaliser l'équilibre des charges, les équations eq(0) et eq(1) prennent la forme suivante :

$$eq(0): V_{REG}/2 + V_{MEMS} = V_{REG}/2 + V_{DACoffset} + (DACbus(0)-512) \cdot K_{DAC} \cdot V_{REG} + (OFFSETbus-512) \cdot K_{OFF} \cdot V_{REG}$$

$$eq(1): V_{REG}/2 - V_{MEMS} = V_{REG}/2 + V_{DACoffset} - (DACbus(1)-512) \cdot K_{DAC} \cdot V_{REG} - (OFFSETbus-512) \cdot K_{OFF} \cdot V_{REG}$$

Si la capacité C1X est plus grande que la capacité C2X par exemple, l'équilibre des charges se fait à une tension supérieure à $V_{REG}/2$ pour la polarisation positive et à une tension inférieure à $V_{REG}/2$ pour une polarisation négative. Si on effectue la soustraction de ces deux équations eq(0) et eq(1), cela donne l'équation eq(2) suivante :

$$eq(2): \quad 2 \cdot V_{MEMS} = (DACbus(0)+DACbus(1)-1024) \cdot K_{DAC} \cdot V_{REG} + 2 \cdot (OFFSETbus-512) \cdot K_{OFF} \cdot V_{REG}$$

DACbus(0)+DACbus(1)-1024 est proportionnel à $V_{MEMS}$, qui est également proportionnelle à l'accélération. Le terme $V_{DACoffset}$ a disparu de l'équation eq(2), ce qui est le but final. Le gain du système dépend donc du choix de $K_{DAC}$. L'écart de tension du capteur MEMS peut aussi toujours être supprimé au moyen d'une bonne sélection du mot binaire OFFSETbus.

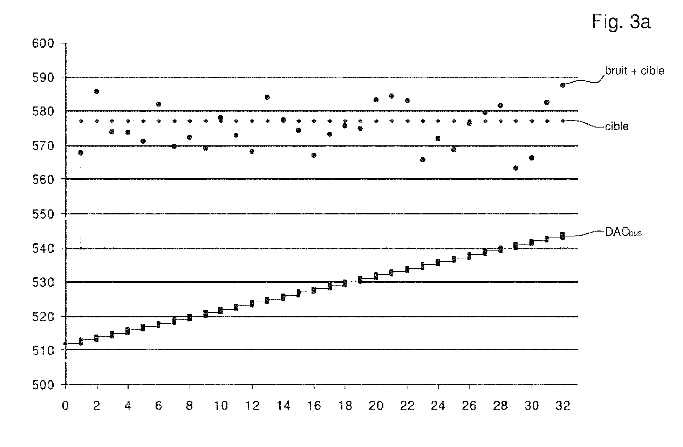

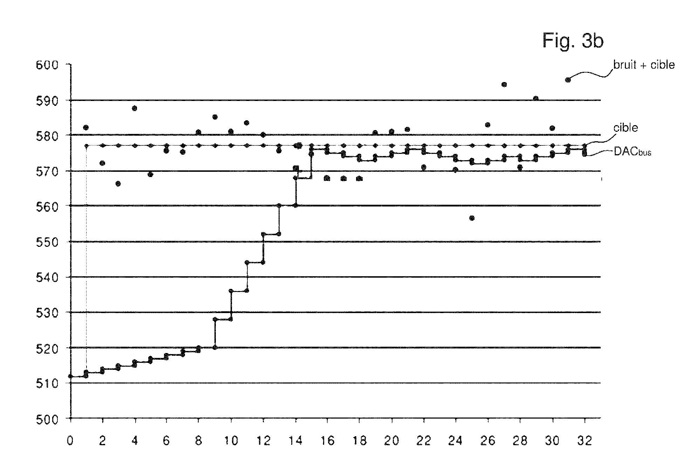

Pour mieux représenter l'évolution des signaux numériques dans au moins une conversion de mesure, on peut se référer aux figures 2, 3a et 3b relatives au procédé de mesure selon l'invention.

A la figure 2, il est représenté un diagramme temporel d'une conversion du procédé de mesure selon l'invention, selon un axe de mesure pour un capteur uniaxe, et une des deux polarisations des électrodes fixes d'une paire de condensateurs. Cependant des graphes identiques peuvent aussi être représentés dans le cas d'une mesure par un capteur triaxial. Sur l'axe x, il est défini le nombre d'échantillons prélevés pour la mesure suite à une des polarisations. Un échantillon pour chaque signal numérique est obtenu dans un cycle de mesure. Sur l'axe y, il est défini le niveau de chaque signal numérique.

Sur ce diagramme temporel, il est représenté l'évolution du signal numérique sans grande variation du paramètre physique à mesurer par rapport à une précédente conversion. La conversion débute en partant du signal numérique stocké de la précédente conversion par exemple au mot binaire à 577. Chaque échantillon du signal numérique DACbus pour les 32 cycles de mesure de la conversion est représenté par un rectangle, alors que la valeur cible à atteindre est représentée par une succession de losanges au niveau de 577. Les décisions prises dans l'unité logique pour les cycles de mesure successifs, sont affectées par le bruit électronique, qui provient notamment du convertisseur numérique-analogique et de l'amplificateur à transfert de charges. Ce bruit additionné à la valeur cible est également représenté par une succession de points ronds pour les cycles de mesure de la conversion.

On remarque sur la figure 2 l'influence du niveau du bruit pour adapter à chaque cycle de mesure le précédent signal numérique. Si le précédent signal numérique ayant généré la tension DAC et plus petit que le niveau cible avec le bruit, une petite valeur de pas est ajoutée au précédent signal binaire pour un cycle de mesure successif. Dans le cas contraire, une petite valeur de pas est soustraite au précédent signal binaire. La petite valeur de pas peut être égale à 1 LSB, voire 2 LSB selon les applications. Comme il n'y a pas d'adaptation à une grande valeur de pas dans ce cas de figure, une moyenne des signaux numériques mémorisés d'au moins une partie finale des cycles de mesure ou de tous les signaux numériques mémorisés successivement, peut être effectuée. Ainsi la valeur numérique mémorisée dans le registre du signal numérique au terme de la conversion, correspond à cette moyenne et peut servir pour une conversion subséquente. La moyenne des signaux numériques représentés à la figure 2 peut être de 576, ce qui est proche de la valeur cible souhaitée à 577.

Aux figures 3a et 3b, il est représenté des diagrammes temporels comparatifs d'une conversion selon un axe de mesure d'une part sans application de l'algorithme auto-adaptatif et d'autre part en appliquant l'algorithme auto-adaptatif du procédé de mesure selon l'invention. Dans ce cas de figure, un brusque changement du paramètre physique à mesurer survient par rapport à une précédente conversion. Le précédent signal numérique mémorisé d'une précédente conversion est 512, et la valeur cible à atteindre est à 577 représentant un brusque changement du paramètre physique à mesurer pour cette nouvelle conversion. Chaque échantillon du signal numérique DACbus pour les 32 cycles de mesure de la conversion est représenté par un rectangle, alors que la valeur cible à atteindre est représentée par une succession de losanges au niveau de 577. Le bruit additionné à la valeur cible est également représenté par une succession de points ronds pour les cycles de mesure de la conversion.

Comme on peut le remarquer sur la figure 3a sans application de l'algorithme auto-adaptatif de la valeur des pas des cycles de mesure, une augmentation continuelle par petite valeur de pas est effectuée à chaque cycle successif de mesure. Cette augmentation continuelle du signal numérique intervient du début à la fin de la conversion en direction de la valeur cible souhaitée. La moyenne des échantillons mémorisés du signal numérique ne fournit ainsi pas la valeur attendue de la mesure du paramètre physique. Cette moyenne de tous les échantillons se situe à 528. Il en est de même de la dernière valeur du signal numérique, qui est encore loin de la valeur cible espérée. Cette dernière valeur du signal numérique est de l'ordre de 544, ce qui est loin de la valeur cible 577, mais peut servir comme valeur numérique pour une nouvelle conversion.

Par contre en regard de la figure 3b avec application de l'algorithme auto-adaptif de la valeur des pas des cycles de mesure, on remarque qu'une adaptation de la valeur de pas est effectuée après par exemple 8 premiers cycles de mesure. La valeur numérique de départ de la conversion à 512 est augmentée d'une petite valeur de pas, c'est-à-dire d'une valeur égale à 1, à chaque premier cycle de mesure. Une fois que le compteur de décisions a compté successivement 8 fois l'état "1" de l'augmentation continuelle du signal numérique, une adaptation de la valeur de pas pour le $9^e$ cycle de mesure est effectuée. La taille des pas est adaptée par exemple à une valeur égale à 8. Comme on peut le remarquer sur la figure 3b, une augmentation à grande valeur de pas du signal numérique de chaque cycle successif est effectuée jusqu'à ce qu'il y ait un changement de signe dans le compteur de décisions. Ce changement de signe intervient au 16e cycle, ce qui signifie que le signal numérique se trouve proche de la valeur cible attendue. Dès cet instant, une réadaptation à une petite valeur de pas est effectuée pour tous les cycles de mesure successifs de la partie finale de la conversion. Une moyenne des échantillons numériques mémorisés du signal numérique depuis le 16e cycle et jusqu'au 32e cycle final peut être exécutée dans l'unité logique. Cette moyenne peut être mémorisée dans le registre correspondant du signal numérique pour servir comme point de départ d'une conversion subséquente.

A partir de la description qui vient d'être faite, de multiples variantes de réalisation du procédé de mesure d'un paramètre physique et du circuit électronique d'interface du capteur capacitif pour sa mise en oeuvre peuvent être conçues par l'homme du métier sans sortir du cadre de l'invention définie par les revendications. Il peut être envisagé de modifier la durée de chaque phase l'une par rapport à l'autre ou la durée de chaque cycle durant les opérations de mesure du paramètre physique, ainsi que le nombre de cycles de mesure successifs pour chaque conversion de mesure. La valeur des grands pas dans des cycles de mesure peut être augmentée ou diminuée progressivement dans une même conversion, ou modifiée d'une conversion à une conversion subséquente. Il peut être prévu de modifier l'ordre des polarisations positive et négative dans chaque cycle de mesure. Il peut aussi être placé dans chaque cycle de mesure au moins deux phases supplémentaires d'un test de fonctionnalité du circuit électronique.

**Revendications**

1. Procédé de mesure d'un paramètre physique au moyen d'un circuit électronique (1) d'interface relié à un capteur capacitif (2), qui comprend au moins deux condensateurs (C1X, C2X) montés en différentiel, dont une électrode commune (CM) est susceptible de se déplacer par rapport à chaque électrode fixe des deux condensateurs pour modifier la valeur capacitive de chaque condensateur lors de la mesure du paramètre physique, ledit circuit électronique comprenant un amplificateur à transfert de charges (4), qui est connecté à l'électrode commune (CM) par l'intermédiaire d'une unité de commutation (3), une unité logique (5) reliée à la sortie de l'amplificateur pour un traitement numérique de l'information fournie par l'amplificateur et la fourniture de signaux numériques de mesure, et un convertisseur numérique-analogique (7) susceptible de fournir une tension de mesure ($V_{DAC}$) aux électrodes par l'intermédiaire de l'unité de commutation (3), la tension de mesure étant définie sur la base d'une conversion d'un mot binaire (DACbus) définissant au moins un des signaux numériques de mesure, le procédé comprenant plusieurs cycles successifs de mesure pour une conversion de mesure, où chaque cycle successif de mesure comprend des étapes :

a) de polariser les électrodes des condensateurs (C1X, C2X, CM) par l'intermédiaire de l'unité de commutation (3) avec une tension de mesure ($V_{DAC}$) fournie par le convertisseur numérique-analogique (7) sur la base d'un premier signal numérique de mesure d'un précédent cycle ou d'un premier mot binaire initial fourni par l'unité logique (5), le premier signal numérique dépendant d'une première polarisation des électrodes fixes des condensateurs,

b) de relier les électrodes fixes des condensateurs (C1X, C2) par l'intermédiaire de l'unité de commutation (3), chacune respectivement aux bornes d'une source de tension d'alimentation ($V_{REG}$, $V_{SS}$) pour une première polarisation des électrodes fixes,

c) de polariser les électrodes des condensateurs (C1X, C2X, CM) par l'intermédiaire de l'unité de commutation (3) avec une tension de mesure ($V_{DAC}$) fournie par le convertisseur numérique-analogique (7) sur la base d'un second signal numérique de mesure d'un précédent cycle ou d'un second mot binaire initial fourni par l'unité logique (5), le second signal numérique dépendant d'une seconde polarisation inverse de la première polarisation des électrodes fixes des condensateurs,

d) de relier les électrodes fixes des condensateurs (C1X, C2) par l'intermédiaire de l'unité de commutation (3), chacune respectivement aux bornes d'une source de tension d'alimentation ($V_{REG}$, $V_{SS}$) pour une seconde polarisation des électrodes fixes, qui est l'inverse de la première polarisation,

**caractérisé en ce que** le procédé débute chaque conversion par des cycles de mesure, dans lesquels les premier et second signaux numériques sont adaptés dans l'unité logique (5) par l'addition ou la soustraction d'une première valeur de pas égale à 1 ou 2 sur la base de l'information d'un état haut ou d'un état bas de la sortie de l'amplificateur à transfert de charges (4) à chaque cycle de mesure, **en ce qu'**un compteur de décisions (13) de l'unité logique (5) compte ou décompte les états successifs de la sortie de l'amplificateur à transferts de charges (4) à chaque cycle de mesure, de manière à adapter les premier et second signaux numériques par l'addition ou la soustraction d'une seconde valeur déterminée de pas supérieur à 2, si le nombre compté ou décompté successivement d'états identiques de la sortie de l'amplificateur à transfert de charges (4), excède un seuil prédéterminé, et **en ce qu'**une détection de changement de signe du comptage ou décomptage du compteur de décisions (13) dans les cycles de mesure à la seconde valeur de pas, est contrôlée dans l'unité logique (5), afin de réadapter la taille des pas à la première valeur de pas en cas de changement de signe, jusqu'au terme de la conversion de mesure.

2. Procédé de mesure selon la revendication 1, pour lequel l'unité logique (5) comprend un premier registre pour mémoriser le premier signal numérique de mesure sur 10 bits, et un second registre pour mémoriser le second signal numérique de mesure sur 10 bits, **caractérisé en ce que** chaque conversion de mesure débute sur la base d'une valeur numérique finale de chaque signal numérique mémorisé dans le premier registre et le second registre (14) d'une précédente conversion.

3. Procédé de mesure selon l'une des revendications précédentes, **caractérisé en ce qu'**une moyenne des signaux numériques successivement mémorisés dans l'unité logique (5) dans au moins une partie finale des cycles successifs de mesure de la conversion, avec l'adaptation des premier et second signaux numériques par l'addition ou la soustraction à chaque cycle de mesure de la première valeur de pas, est effectuée pour mémoriser la moyenne de chaque signal numérique comme valeur numérique finale dans un registre correspondant à fournir pour débuter une conversion subséquente.

4. Procédé de mesure selon l'une des revendications 1 et 2, **caractérisé en ce que** si la conversion de mesure se termine par un cycle de mesure avec une adaptation à la seconde valeur de pas de chaque signal numérique de mesure, il est sélectionné la dernière valeur numérique stockée de chaque signal numérique comme valeur numérique finale au terme de la conversion à fournir pour une conversion subséquente.

5. Procédé de mesure selon l'une des revendications précédentes, pour lequel le capteur capacitif est du type triaxial avec trois paires de condensateurs (C1X, C2X, C1Y, C2Y, C1Z, C2Z) montés en différentiel avec une électrode commune (CM) par paire ou pour toutes les paires et deux électrodes fixes pour chaque paire, et l'unité logique (5) du circuit électronique est en mesure de fournir des premier et second signaux numériques de mesure pour chaque axe de mesure X, Y et Z, **caractérisé en ce que** le procédé comprend 12 phases successives par cycle de mesure, qui consistent à répéter successivement pendant les six premières phases, les étapes a) et b) pour chaque axe X, Y, Z avec le premier signal numérique correspondant à l'axe sélectionné, et à répéter successivement pendant les six dernières phases, les étapes c) et d) pour chaque axe X, Y, Z avec le second signal numérique correspondant à l'axe sélectionné, et **en ce que** le compteur de décisions (13) compte ou décompte pour chaque axe de mesure les états successifs de la sortie de l'amplificateur à transferts de charges (4) à chaque cycle de mesure pour adapter les premier et second signaux numériques de chaque axe par l'addition ou la soustraction de la seconde valeur déterminée de pas supérieure à 2, si le nombre compté ou décompté successivement d'états identiques de la sortie de l'amplificateur à transfert de charges (4), excède le seuil prédéterminé.

6. Procédé de mesure selon l'une des revendications précédentes, **caractérisé en ce qu'**il est effectué 16, 32, 40 ou 64 cycles de mesure dans chaque conversion de mesure, **en ce que** la première valeur de pas est égale à 1, et **en ce que** la seconde valeur de pas est supérieure ou égale à 8.

7. Procédé de mesure selon la revendication 6, **caractérisé en ce que** la seconde valeur de pas supérieure ou égale à 8 est variable dans une même conversion ou d'une conversion à une autre conversion de mesure.

8. Circuit électronique (1) d'interface d'un capteur capacitif, qui comprend une paire de condensateurs (C1X, C2X) montés en différentiel, pour la mise en oeuvre du procédé de mesure selon l'une des revendications précédentes, le circuit électronique comprenant un amplificateur à transfert de charges (4) connecté à l'électrode commune (CM) par l'intermédiaire d'une unité de commutation (3), une unité logique (5) reliée à la sortie de l'amplificateur pour un traitement numérique de l'information fournie par l'amplificateur et la fourniture de premier et second signaux numériques de mesure dépendant respectivement d'une première polarisation des électrodes fixes des condensateurs et d'une seconde polarisation inverse de la première polarisation, et un convertisseur numérique-analogique (7) susceptible de fournir une tension de mesure ($V_{DAC}$) aux électrodes par l'intermédiaire de l'unité de commutation (3), la tension de mesure étant définie sur la base d'une conversion du mot binaire (DACbus) relatif au premier signal numérique stocké dans un premier registre de l'unité logique (5) ou au second signal numérique de mesure stocké dans un second registre de l'unité logique (5), **caractérisé en ce que** l'unité logique (5) comprend un élément (15) d'exécution d'une moyenne relié aux registres (14), l'élément (15) étant destiné à effectuer une moyenne des premiers signaux numériques successifs mémorisés et une moyenne des seconds signaux numériques successifs mémorisés dans au moins une partie finale de cycles de mesure d'une conversion avec adaptation à une première valeur de pas à chaque cycle de mesure, et un compteur de décisions (13) susceptible de compter ou décompter des états successifs de la sortie de l'amplificateur à transferts de charges (4) à chaque cycle de mesure, pour adapter les premier et second signaux numériques par l'addition ou la soustraction d'une seconde valeur déterminée de pas supérieure à 2, si le nombre compté ou décompté successivement d'états identiques de la sortie de l'amplificateur à transfert de charges (4), excède un seuil prédéterminé, le compteur de décisions (13) étant également destiné à commander la sélection de la dernière valeur numérique du premier signal numérique et du second signal numérique, si la conversion de mesure se termine par un cycle de mesure avec une adaptation à la seconde valeur de pas de chaque signal numérique de mesure.

9. Circuit électronique (1) selon la revendication 8, en tant qu'interface d'un capteur capacitif triaxial, qui comprend trois paires de condensateurs (C1X, C2X, C1Y, C2Y, C1Z, C2Z) montés en différentiel, **caractérisé en ce qu'**il comprend un unique amplificateur à transfert de charge (4) pour la mesure selon les trois axes X, Y, Z de mesure du capteur, l'amplificateur étant capable de fournir une information du type numérique à l'unité logique (5) pour permettre au compteur de décisions (13) d'effectuer un comptage ou un décomptage en fonction de l'état de la sortie de l'amplificateur à transfert de charges (4) dans chaque cycle successif de mesure d'une conversion, et **en ce que** l'unité logique (5) fournit des premier et second signaux numériques de mesure pour chaque axe de mesure X, Y, Z.

10. Circuit électronique (1) selon la revendication 9, **caractérisé en ce que** l'unité logique (5) comprend six registres pour mémoriser les premier et second signaux numériques de mesure de chaque axe, chaque registre étant défini sur 10 bits.

11. Circuit électronique (1) selon l'une des revendications 8 à 10, **caractérisé en ce qu'**il comprend un multiplexeur (16) commandé par un signal de commande du compteur de décisions (13), de manière à fournir en sortie soit le dernier signal numérique de chaque registre, si la conversion de mesure se termine par un cycle de mesure avec une adaptation à la seconde valeur de pas de chaque signal numérique de mesure, soit la moyenne des premiers et seconds signaux numériques successifs mémorisés de chaque axe dans au moins une partie finale de cycles de mesure d'une conversion avec adaptation à une première valeur de pas à chaque cycle de mesure, et un élément (17) de combinaison des premier et second signaux numériques de chaque axe reçus du multiplexeur (16), afin de fournir des signaux numériques de sortie de chaque axe (OUT$_{DX}$, OUT$_{DY}$, OUT$_{DZ}$).

**Patentansprüche**

1. Verfahren zum Messen eines physikalischen Parameters mittels einer elektronischen Schnittstellenschaltung (1), die mit einem kapazitiven Sensor (2) verbunden ist, der wenigstens zwei differentiell geschaltete Kondensatoren (C1 X, C2X) umfasst, wovon sich eine gemeinsame Elektrode (CM) in Bezug auf jede feste Elektrode der zwei Kondensatoren verlagern kann, um den kapazitiven Wert jedes Kondensators bei der Messung des physikalischen Parameters zu modifizieren, wobei die elektronische Schaltung umfasst: einen Ladungsübertragungsverstärker (4), der mit der gemeinsamen Elektrode (CM) über eine Kommutationseinheit (3) verbunden ist, eine Logikeinheit (5), die mit dem Ausgang des Verstärkers verbunden ist, um eine digitale Verarbeitung der von dem Verstärker gelieferten Informationen und die Lieferung der digitalen Messdaten auszuführen, und einen Digital/Analog-Umsetzer (7), der eine Messspannung (V$_{DAC}$) an die Elektroden über die Kommutationseinheit (3) liefern kann, wobei die Messspannung anhand einer Umsetzung eines Binärwortes (DACbus), das wenigstens eines der digitalen Messsignale definiert, definiert ist,

wobei das Verfahren mehrere aufeinander folgende Messzyklen für eine Messumsetzung umfasst, wobei jeder aufeinander folgende Messzyklus die folgenden Schritte umfasst:

a) Vorspannen der Elektroden der Kondensatoren (C1X, C2X, CM) über die Kommutationseinheit (3) mit einer Messspannung (V$_{DAC}$), die von dem Digital/Analog-Umsetzer (7) anhand eines ersten digitalen Messsignals eines vorhergehenden Zyklus oder eines ersten anfänglichen Binärwortes, das von der Logikeinheit (5) geliefert wird, bereitgestellt wird, wobei das erste digitale Signal von einer ersten Vorspannung der festen Elektroden der Kondensatoren abhängt,
b) Verbinden jeder der festen Elektroden der Kondensatoren (C1X, C2) über die Kommutationseinheit (3) mit den entsprechenden Anschlüssen einer Versorgungsspannungsquelle (V$_{REG}$, V$_{SS}$) für eine erste Vorspannung der festen Elektroden,
c) Vorspannen der Elektroden der Kondensatoren (C1X, C2X, CM) über die Kommutationseinheit (3) mit einer Messspannung (V$_{DAC}$), die von dem Digital/Analog-Umsetzer (7) anhand eines zweiten digitalen Messsignals eines vorhergehenden Zyklus oder eines zweiten anfänglichen Binärwortes, das von der Logikeinheit (5) geliefert wird, bereitgestellt wird, wobei das zweite digitale Signal von einer in Bezug auf die erste Vorspannung invertierten zweiten Vorspannung der festen Elektroden der Kondensatoren abhängt,

d) Verbinden jeder der festen Elektroden der Kondensatoren (C1X, C2) über die Kommutationseinheit (3) mit den entsprechenden Anschlüssen einer Versorgungsspannungsquelle ($V_{REC}$, $V_{SS}$) für eine zweite Vorspannung der festen Elektroden, die in Bezug auf die erste Vorspannung invertiert ist,

**dadurch gekennzeichnet, dass** das Verfahren jede Umsetzung mit Messzyklen beginnt, in denen das erste und das zweite digitale Signal in der Logikeinheit (5) durch die Addition oder die Subtraktion eines ersten Schrittwertes, der gleich 1 oder 2 ist, anhand der Informationen eines hohen Zustands oder eines tiefen Zustands des Ausgangs des Ladungsübertragungsverstärkers (4) in jedem Messzyklus angepasst werden, dass ein Entscheidungszähler (13) der Logikeinheit (5) die aufeinander folgenden Zustände des Ausgangs des Ladungsübertragungsverstärkers (4) in jedem Messzyklus aufwärts oder abwärts zählt, derart, dass das erste und das zweite digitale Signal durch die Addition oder Subtraktion eines zweiten bestimmten Schrittwertes größer als 2 angepasst werden, falls die aufwärts oder abwärts gezählte Anzahl aufeinander folgender, übereinstimmender Zustände des Ausgangs des Ladungsübertragungsverstärkers (4) einen vorgegebenen Schwellenwert überschreitet, und dass eine Detektion einer Änderung des Vorzeichens der Aufwärts- oder Abwärtszählung des Entscheidungszählers (13) in den Messzyklen des zweiten Schrittwertes in der Logikeinheit (5) kontroiliert wird, um die Größe der Schritte des ersten Schrittwertes im Fall einer Vorzeichenänderung bis zum Ende der Messumsetzung erneut anzupassen.

2. Messverfahren nach Anspruch 1, wobei die Logikeinheit (5) ein erstes Register zum Speichern des ersten digitalen Messsignals mit 10 Bits und ein zweites Register zum Speichern des zweiten digitalen Messsignals mit 10 Bits umfasst, **dadurch gekennzeichnet, dass** jede Messumsetzung anhand eines abschließenden digitalen Wertes jedes digitalen Signals einer vorhergehenden Umsetzung, die in dem ersten Register und in dem zweiten Register (14) gespeichert sind, beginnt.

3. Messverfahren nach einem der vorhergehenden Ansprüche, **dadurch gekennzeichnet, dass** eine Mittelung der digitalen Signale, die nacheinander in einer Logikeinheit (5) wenigstens in einem abschließenden Teil der aufeinander folgenden Messzyklen der Umsetzung gespeichert werden, mit Anpassung des ersten und des zweiten digitalen Signals durch die Addition oder die Subtraktion in jedem Messzyklus des ersten Schrittwertes ausgeführt wird, um den Mittelwert jedes digitalen Signals als abschließenden digitalen Wert in einem entsprechenden Register zu speichern, der bereitzustellen ist, um eine nachfolgende Umsetzung zu beginnen.

4. Messverfahren nach einem der Ansprüche 1 und 2, **dadurch gekennzeichnet, dass** dann, wenn die Messumsetzung mit einem Messzyklus mit einer Anpassung an den zweiten Schrittwert jedes digitalen Messsignals endet, der letzte gespeicherte digitale Wert jedes digitalen Signals als ein abschließender digitaler Wert am Ende der Umsetzung gewählt wird, der für eine nachfolgende Umsetzung bereitzustellen ist.

5. Messverfahren nach einem der vorhergehenden Ansprüche, bei dem der kapazitive Sensor vom dreiachsigen Typ mit drei differentiell geschalteten Paaren von Kondensatoren (C1X, C2X, C1Y, C2Y, C1Z, C2Z) mit einer gemeinsamen Elektrode (CM) pro Paar oder für sämtliche Paare und zwei festen Elektroden pro Paar ist und die Logikeinheit (5) der elektronischen Schaltung in der Lage ist, erste und zweite digitale Messsignale für jede Messachse X, Y und Z zu liefern, **dadurch gekennzeichnet, dass** das Verfahren 12 aufeinander folgende Phasen pro Messzyklus umfasst, die darin bestehen, nacheinander während der sechs ersten Phasen die Schritte a) und b) für jede Achse X, Y, Z mit dem ersten digitalen Signal, das der gewählten Achse entspricht, zu wiederholen und nacheinander während der sechs letzten Phasen die Schritte c) und d) für jede Achse X, Y, Z mit dem zweiten digitalen Signal, das der gewählten Achse entspricht, zu wiederholen, und dass der Entscheidungszähler (13) für jede Messachse die aufeinander folgenden Zustände des Ausgangs des Ladungsübertragungsverstärkers (4) in jedem Messzyklus aufwärts oder abwärts zählt, um die ersten und zweiten digitalen Signale jeder Achse durch die Addition oder die Subtraktion des zweiten bestimmten Schrittwertes größer als 2 anzupassen, falls die nacheinander aufwärts oder abwärts gezählte Anzahl übereinstimmender Zustände des Ausgangs des Ladungsübertragungsverstärkers (4) den vorgegebenen Schwellenwert überschreitet.

6. Messverfahren nach einem der vorhergehenden Ansprüche, **dadurch gekennzeichnet, dass** es in 16, 32, 40 oder 64 Messzyklen in jeder Messumsetzung ausgeführt wird, dass der erste Schrittwert gleich 1 ist und dass der zweite Schrittwert größer oder gleich 8 ist.

7. Messverfahren nach Anspruch 6, **dadurch gekennzeichnet, dass** der zweite Schrittwert, der größer oder gleich 8 ist, in derselben Messumsetzung oder von einer Messumsetzung zu einer anderen Messumsetzung variabel ist.

8. Elektronische Schnittstellenschaltung (1) eines kapazitiven Sensors, der ein Paar differentiell geschaltete Kondensatoren (C1X, C2X) umfasst, um das Messverfahren nach einem der vorhergehenden Ansprüche auszuführen, wobei die elektronische Schaltung einen Ladungsübertragungsverstärker (4), der mit der gemeinsamen Elektrode (CM) über eine Kommutationseinheit (3) verbunden ist, eine Logikeinheit (5), die mit dem Ausgang des Verstärkers verbunden ist, um die von dem Verstärker gelieferten Informationen digital zu verarbeiten und um ein erstes und ein zweites digitales Messsignal, die von einer ersten Vorspannung der festen Elektroden der Kondensatoren bzw. von einer in Bezug auf die erste Vorspannung invertierten zweiten Vorspannung abhängen, bereitzustellen, und einen Digital/Analog-Umsetzer (7), der eine Messspannung ($V_{DAC}$) über die Kommutationseinheit (3) an die Elektroden liefern kann, umfasst, wobei die Messspannung anhand einer Umsetzung eines Binärwortes (DACbus) in Bezug auf das erste digitale Signal, das in einem ersten Register der Logikeinheit (5) gespeichert ist, oder in Bezug auf das zweite digitale Messsignal, das in einem zweiten Register der Logikeinheit (5) gespeichert ist, definiert ist, **dadurch gekennzeichnet, dass** die Logikeinheit (5) umfasst: ein Element (15) zum Ausführen einer Mittelung, das mit den Registern (14) verbunden ist, wobei das Element (15) dazu bestimmt ist, eine Mittelung der gespeicherten ersten aufeinander folgenden digitalen Signale und eine Mittelung der zweiten gespeicherten aufeinander folgenden digitalen Signale wenigstens in einem abschließenden Teil der Messzyklen einer Umsetzung mit Anpassung an einen ersten Schrittwert in jedem Messzyklus auszuführen, und einen Entscheidungszähler (13), der aufeinander folgende Zustände des Ausgangs des Ladungsübertragungsverstärkers (4) in jedem Messzyklus aufwärts oder abwärts zählen kann, um die ersten und zweiten digitalen Signale durch die Addition oder die Subtraktion eines zweiten bestimmten Schrittwertes größer als 2 anzupassen, falls die nacheinander aufwärts oder abwärts gezählte Anzahl übereinstimmender Zustände des Ausgangs des Ladungsübertragungsverstärkers (4) einen vorgegebenen Schwellenwert überschreitet, wobei der Entscheidungszähler (13) auch dazu bestimmt ist, die Auswahl des ersten digitalen Wertes des ersten digitalen Signals und des zweiten digitalen Signals zu steuern, falls die Messumsetzung mit einem Messzyklus mit einer Anpassung an den zweiten Schrittwert jedes digitalen Messsignals endet.

9. Elektronische Schaltung (1) nach Anspruch 8 als Schnittstelle eines dreiachsigen kapazitiven Sensors, der drei Paare von differentiell geschalteten Kondensatoren (C1X, C2X, C1Y, C2Y, C1Z, C2Z) umfasst, **dadurch gekennzeichnet, dass** sie einen einzigen Ladungsübertragungsverstärker (4) für die Messung längs der drei Messachsen X, Y, Z des Sensors umfasst, wobei der Verstärker Informationen des digitalen Typs für die Logikeinheit (5) bereitstellen kann, um dem Entscheidungszähler (13) zu ermöglichen, eine Aufwärts- oder Abwärtszählung als Funktion des Zustands des Ausgangs des Ladungsübertragungsverstärkers (4) in jedem aufeinander folgenden Messzyklus einer Umsetzung auszuführen, und dass die Logikeinheit (5) erste und zweite digitale Messsignale für jede Messachse X, Y, Z liefert.

10. Elektronische Schaltung (1) nach Anspruch 9, **dadurch gekennzeichnet, dass** die Logikeinheit (5) sechs Register zum Speichern der ersten und zweiten digitalen Messsignale jeder Achse umfasst, wobei jedes Register mit 10 Bits definiert ist.

11. Elektronische Schaltung (1) nach einem der Ansprüche 8 bis 10, **dadurch gekennzeichnet, dass** sie umfasst: einen Multiplexer (16), der durch ein Steuersignal des Entscheidungszählers (13) gesteuert wird, derart, dass am Ausgang entweder das letzte digitale Signal jedes Registers bereitgestellt wird, falls die Messumsetzung mit einem esszyklus mit einer Anpassung an den zweiten Schrittwert jedes digitalen Messsignals endet, oder der Mittelwert der ersten und zweiten gespeicherten aufeinander folgenden digitalen Signale jeder Achse wenigstens in einem abschließenden Teil von Messzyklen einer Umsetzung mit Anpassung an einen ersten Schrittwert jedes Messzyklus bereitgestellt wird, und ein Element (17) zum Kombinieren der ersten und zweiten digitalen Signale jeder Achse, die von dem Multiplexer (16) empfangen werden, um digitale Ausgangssignale jeder Achse ($OUT_{DX}$, $OUT_{DY}$, $OUT_{DZ}$) bereitzustellen.

**Claims**

1. Method of measuring a physical parameter by means of an electronic interface circuit (1) connected to a capacitive sensor (2), which includes at least two differential connected capacitors (C1X, C2X) whose a common electrode (CM) is capable of moving relative to each fixed electrode of the two capacitors to alter the capacitive value of each capacitor when the physical parameter is being measured, said electronic circuit including a charge transfer amplifier (4), which is connected to the common electrode (CM) via a switching unit (3), a logic unit (5) connected to the amplifier output for digital processing of the data supplied by the amplifier and for supplying digital measuring signals, and a digital-analogue converter (7) capable of supplying a measurement voltage ($V_{DAC}$) to the electrodes via the switching unit (3), the measurement voltage being defined on the basis of a binary word (DACbus) conversion defining at least one of the digital measuring signals,
the method including several successive measuring cycles for a measurement conversion, wherein each successive measuring cycle comprises the steps of:

a) biasing the electrodes of the capacitors (C1X, C2X, CM) via the switching unit (3) with a measuring voltage (V$_{DAC}$) supplied by the digital-analogue converter (7) on the basis of a first digital measuring signal from a preceding cycle or a first initial binary word supplied by the logic unit (5), the first digital signal depending on a first biasing of the fixed electrodes of the capacitors,

b) connecting the fixed electrodes of the capacitors (C1X, CX) via the switching unit (3) respectively each to the terminals of a supply voltage (V$_{REG}$, V$_{SS}$) source for a first biasing of the fixed electrodes,

c) biasing the electrodes of the capacitors (C1X, C2X, CM) via the switching unit (3) with a measuring voltage (V$_{DAC}$) supplied by the digital-analogue converter (7) on the basis of a second digital measuring signal from a preceding cycle or a second initial binary word supplied by the logic unit (5), the second digital signal depending on a second biasing which is the reverse of the first biasing of the fixed electrodes of the capacitors,

d) connecting the fixed electrodes of the capacitors (C1X, CX) via the switching unit (3) respectively each to the terminals of a supply voltage (V$_{REG}$, V$_{SS}$) source for a second biasing of the fixed electrodes, which is the inverse of the first biasing,

**characterized in that** the method starts each conversion with measuring cycles, in which the first and second digital signals are adapted in the logic unit (5), by the addition or subtraction of a first step value equal to 1 or 2, on the basis of information as to the high output state or low output state of the charge transfer amplifier (4) in each measuring cycle, **in that** a decision counter (13) of the logic unit (5) counts or counts down the successive output states of the charge transfer amplifier (4) in each measuring cycle, so as to adapt the first and second digital signals by the addition or subtraction of a second determined step value higher than 2, if the number of identical states successively counted or counted down at the output of the charger transfer amplifier (4) exceeds a predetermined threshold, and **in that** the detection of a change of sign in the count or countdown of the decision counter (13) in the measuring cycles to the second step value, is checked in the logic unit (5) so as to re-adapt the step size to the first step value in the event of a change of sign, until the end of the measurement conversion.

2. Measuring method according to claim 1, wherein the logic unit (5) includes a first register for storing the first digital measuring signal in 10 bits, and a second register for storing the second digital measuring signal in 10 bits, **characterized in that** each measurement conversion starts on the basis of a final digital value for each digital signal stored in the first register and the second register (14) from a preceding conversion.

3. Measuring method according to any of the preceding claims, **characterized in that** a mean is calculated of the digital signals stored in succession in the logic unit (5) in at least a final part of the successive measuring cycles of the conversion, with adaptation of the first and second digital signals by the addition or subtraction of the first step value in each measuring cycle, in order to store the mean of each digital signal in the corresponding register as the final digital value to be supplied to start a subsequent conversion.

4. Measuring method according to any of claims 1 and 2, **characterized in that** if the measurement conversion ends in a measuring cycle with adaptation of each digital measuring signal to the second step value, the last digital value stored for each digital signal at the end of the conversion is selected as the final digital value to be supplied for a subsequent conversion.

5. Measuring method according to any of the preceding claims, wherein the capacitive sensor is of the tri-axis type with three pairs of differential connected capacitors (C1X, C2X, C1Y, C2Y, C1Z, C2Z) with one common electrode (CM) per pair or for all the pairs and two fixed electrodes for each pair, and the logic unit (5) of the electronic circuit is capable of supplying first and second digital measuring signals for each measuring axis X, Y and Z, **characterized in that** the method includes 12 successive phases per measuring cycle, which consist in repeating steps a) and b) in succession during the first six phases for each axis X, Y, Z with the first digital signal corresponding to the selected axis, and in repeating steps c) and d) in succession during the last six phases for each axis X, Y, Z with the second digital signal corresponding to the selected axis, and **in that** the decision counter (13) counts or counts down for each measurement axis the successive output states of the charge transfer amplifier (4) in each measuring cycle so as to adapt the first and second digital signals of each axis by the addition or subtraction of the second determined step value which is higher than 2, if the number of successive output states of the charge transfer amplifier (4) counted or counted down exceeds the predetermined threshold.

6. Measuring method according to any of the preceding claims, **characterized in that** 16, 32, 40 or 64 measuring cycles are carried out in each measurement conversion, **in that** the first step value is equal to 1 and **in that** the second step value is greater than or equal to 8.

7. Measuring method according to claim 6, **characterized in that** the second step value greater than or equal to 8 is variable within the same conversion or from one measurement conversion to another.

8. Electronic interface circuit (1) for a capacitive sensor, which includes a pair of differential connected capacitors (C1X, C2X) for implementing the measuring method according to any of the preceding claims, the electronic circuit including a charge transfer amplifier (4) connected to the common electrode (CM) via a switching unit (3), a logic unit (5) connected to the amplifier output for digital processing of the data supplied by the amplifier and for supplying first and second digital measuring signals, dependent respectively on a first biasing of the fixed electrodes of the capacitors and a second biasing which is the reverse of the first biasing, and a digital-analogue converter (7) capable of supplying a measuring voltage ($V_{DAC}$) to the electrodes via the switching unit (3), the measuring voltage being defined on the basis of a binary word (DACbus) conversion relating to the first digital signal stored in a first register of the logic unit (5) or the second digital measuring signal stored in a second register of the logic unit (5), **characterized in that** the logic unit (5) includes a mean calculation element (15) connected to the registers (14), the element (15) being intended to calculate the mean of the first successive stored digital signals and the mean of the second successive stored digital signals in at least a final part of the measuring cycles of a conversion with adaptation to a first step value in each measuring cycle, and a decision counter (13) capable of counting or counting down successive output states of the charge transfer amplifier (4) in each measuring cycle, to adapt the first and second digital signals by the addition or subtraction of a second determined step value greater than 2 if the number of successive identical states counted or counted down at the output of the charge transfer amplifier (4) exceeds a predetermined threshold, the decision counter (13) being also intended to control the selection of the last digital value of the first digital signal and the second digital signal, if the measurement conversion ends in a measuring cycle with adaptation of each digital measuring signal to the second step value.

9. Electronic circuit (1) according to claim 8, as an interface for a tri-axis capacitive sensor, which includes three pairs of differential connected capacitors (C1X, C2X, C1Y, C2Y, C1Z, C2Z), **characterized in that** it includes a single charge transfer amplifier (4) for measurement on the three measuring axes X, Y and Z of the sensor, the amplifier being capable of supplying digital data to the logic unit (5), to allow the decision counter (13) to carry out a count or countdown according to the output state of the charge transfer amplifier (4) in each successive measuring cycle of a conversion, and **in that** the logic unit (5) supplies first and second digital measuring signals for each measurement axis X, Y and Z.

10. Electronic circuit (1) according to claim 9, **characterized in that** the logic unit (5) includes six registers for storing the first and second digital measuring signals for each axis, each register being defined in 10 bits.

11. Electronic circuit (1) according to any of claims 8 to 10, **characterized in that** it includes a multiplexer (16) operated by a control signal from the decision counter (13), so as to supply at output either the last digital signal of each register, if the measurement conversion ends in a measuring cycle with adaptation of each digital measuring signal to the second step value, or the mean of the first and second successive stored digital signals of each axis in at least a final part of the measuring cycles of a conversion with adaptation to the first step value in each measuring cycle, and an element (17) for combining the first and second digital signals of each axis received from the multiplexer (16) in order to supply digital output signals for each axis ($OUT_{DX}$, $OUT_{DY}$, $OUT_{DZ}$).

Fig. 1

Fig. 2

bruit + cible

DAC_bus

cible

Fig. 3a

Fig. 3b

bruit + cible

cible

DAC$_{bus}$

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 1835263 A
- WO 2004113930 A
- WO 2008107737 A
- EP 2343507 A
- EP 2343507 A1

**Littérature non-brevet citée dans la description**

- **MM. H. LEUTHOLD ; F. RUDOLPH.** *Sensors and actuators,* 1990, vol. A21-A23, 278-281
- A 1 mV MOS Comparator. *IEEE J. Solid-State Circuits,* Juin 1978, vol. SC-13, 294-298